(19) **Europäisches Patentamt / European Patent Office / Office européen des brevets**

(11) **EP 2 309 548 A2**

(12) **EUROPEAN PATENT APPLICATION**

(43) Date of publication:
**13.04.2011 Bulletin 2011/15**

(51) Int Cl.:
*H01L 31/0336* (2006.01)    *H01L 31/032* (2006.01)

(21) Application number: **10186699.4**

(22) Date of filing: **06.10.2010**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **09.10.2009 JP 2009235188**

(71) Applicant: **FUJIFILM Corporation
Tokyo (JP)**

(72) Inventor: **Yamamoto, Kana
Kanagawa (JP)**

(74) Representative: **Klunker . Schmitt-Nilson . Hirsch
Patentanwälte
Destouchesstrasse 68
80796 München (DE)**

(54) **Photoelectric conversion device, method for producing the same and solar battery**

(57)    A photoelectric conversion device (1) includes a photoelectric conversion layer (30) which mainly composed of a compound semiconductor containing a group Ib element, at least two group IIIb elements including Ga, and a group VIb element and contains an alkaline(-earth) metal. Concentration distributions of the alkaline (-earth) metal and Ga in the photoelectric conversion layer (30) in the thickness direction includes a valley with the lowest concentration and an area with a higher concentration between a substrate (10, 11) and the valley, and satisfy Expressions (1) and (2) below:

$$1.0 \times 10^{-6} \leq A_N \text{ [mol/cc]} \leq 2.0 \times 10^{-5} \quad (1)$$

and

$$1.0 \leq C_N/C_G \quad (2),$$

where $A_N$ represents the alkaline (-earth) metal concentration at the valley, $B_N$ represents the highest alkaline (-earth) metal concentration between the substrate and the valley, $A_G$ represents the Ga concentration at the valley, $B_G$ represents the highest Ga concentration between the substrate and the valley, $C_N = B_N/A_N$, and $C_G = B_G/A_G$.

EP 2 309 548 A2

**(Cont. next page)**

FIG.3

**Description**

BACKGROUND OF THE INVENTION

Field of the Invention

The present invention relates to a photoelectric conversion device and a method for producing the photoelectric conversion device, as well as a solar battery using the photoelectric conversion device.

Description of the Related Art

Photoelectric conversion devices having a layered structure, which includes a first electrode (back electrode), a photoelectric conversion layer, a buffer layer and a second electrode (translucent electrode), are used in applications such as solar batteries.

The main stream of conventional solar batteries has been Si solar batteries, which use bulk single-crystal Si or polycrystal Si, or thin-film amorphous Si. On the other hand, compound semiconductor solar batteries, which do not depend on Si, are now being researched and developed. As the compound semiconductor solar batteries, those of a bulk type, such as GaAs solar batteries, etc., and those of a thin-film type, such as CIS (Cu-In-Se) or CIGS (Cu-In-Ga-Se) solar batteries, which contain a group Ib element, a group IIIb element and a group VIb element, are known. The CI (G) S solar batteries are reported to have a high light absorption rate and high photoelectric conversion efficiency.

Description of element groups herein is based on the short-period form of the periodic table. The compound semiconductor containing a group Ib element, a group IIIb element and a group VIb element may herein be referred to as a "group I-II I-VI semiconductor".

CIS and/or CIGS are collectively described herein as "CI (G)S". CI (G) S is a compound semiconductor represented by the general formula below:

$$Cu_{1-z}In_{1-x}Ga_xSe_{2-y}S_y$$

(wherein $0 \leq x \leq 1$, $0 \leq y \leq 2$, $0 \leq z \leq 1$), and it is a CIS semiconductor when $x = 0$ or a CIGS semiconductor when $x > 0$.

With the photoelectric conversion devices, such as the CI (G) S photoelectric conversion devices, it is known that the photoelectric conversion efficiency is improved by diffusing an alkaline (-earth) metal, preferably Na, in the photoelectric conversion layer. The alkaline(-earth) metal is said to serve to passivate defects that cause a loss in photoelectric conversion efficiency (see, for example, D. Rudmann et al., "Na incorporation into Cu(In,Ga)Se2 for high-efficiency flexible solar cells on polymer foils", Journal of Applied Physics, Vol. 97, 084903, pp. 084903-1 - 084903-5, 2005, which is hereinafter referred to as Non-Patent Document 1). The "alkaline(-earth) metal" herein refers to an alkali metal and/or an alkaline-earth metal.

Conventionally, a soda lime glass substrate containing Na is used to diffuse Na in the photoelectric conversion layer. In a case where a substrate with a small alkaline(-earth) metal content is used, it has been proposed to provide an alkaline (-earth) metal layer between the substrate and the photoelectric conversion layer for supplying the alkaline (-earth) metal to the photoelectric conversion layer during formation of the photoelectric conversion layer.

Since the alkaline (-earth) metal is supplied and diffused into the photoelectric conversion layer from the substrate or the alkaline(-earth) metal layer, the alkaline(-earth) metal in the photoelectric conversion layer usually has a distribution in the thickness direction. It is believed that, by optimizing the concentration distribution of the alkaline(-earth) metal in the photoelectric conversion layer in the thickness direction, a photoelectric conversion device which has less defects causing a loss in photoelectric conversion across the thickness direction and high photoelectric conversion efficiency can be provided.

Further, it is known that the photoelectric conversion efficiency is improved by varying the concentration of Ga in the CIGS layer in the thickness direction to vary the bandgap in the thickness direction. As the structure having a gradient potential, a single grading structure where a plot of the relationship between the position in the thickness direction and the potential has one gradient, a double grading structure where a plot of the relationship between the position in the thickness direction and the potential has two gradients, etc., are known, and it is said that the double grading structure is more preferred.

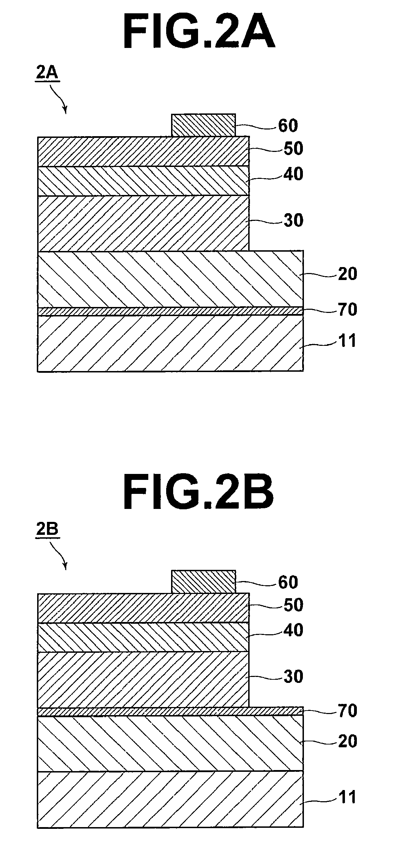

Japanese Unexamined Patent Publication No. 2004-158556 (which is hereinafter referred to as Patent Document 1) discloses a photoelectric conversion device including a photoelectric conversion layer, which contains, as the main component, a group I-III-VI semiconductor containing Ga as the group IIIb element and contains Na, wherein the concentrations of Na and Ga in the photoelectric conversion layer in the thickness direction are the highest at a surface of the photoelectric conversion layer facing the second electrode (translucent electrode), the concentrations once decrease toward the first electrode (back electrode) and then increase to be constant at a level lower than the concentrations at the surface facing the second electrode (translucent electrode) (see claim 1 and FIG. 2).

Patent Document 1 teaches that the concentrations of Na and Ga in the photoelectric conversion layer in the thickness direction are preferably the lowest in an area in the range from D/6 to D/3 from the surface facing the second electrode (translucent electrode), where D is the thickness of the photoelectric conversion layer (see claim 2) . In Patent Document 1, the film formation is achieved using selenization, which is a common film formation method to form a CIGS layer.

In Patent Document 1, preferred positions for a valley position having the lowest Na concentration and a valley position having the lowest Ga concentration are defined. However, Patent Document 1 discloses only one example where the valley positions for the Na concentration and the Ga concentration were 0.2D, and only one comparative example where no alkali metal supplying layer was provided. Further, the example and the comparative example have the same level of conversion efficiency. No detailed study as to what type of concentration distribution is preferred is made in Patent Document 1, and no advantage of the example is shown. Further, no reason is given in Patent Document 1 for why the concentration distributions defined in claims 1 and 2 are preferred.

Patent Document 1 discloses no specific numerical values of a preferred concentration distribution, other than the valley position. Basically, the valley position of the Na concentration in the thickness direction is determined by the concentration distribution of Ga. Therefore, optimization of the effect of passivation of defects causing a loss in photoelectric conversion efficiency cannot be achieved only by optimizing the valley position of the Na concentration in the thickness direction. That is, it is impossible to provide highly efficient devices in a stable manner only by defining the valley position, since an amount of the alkaline(-earth) metal to be supplied and the state of diffusion thereof are not optimized.

Further, since the defects in the photoelectric conversion layer vary depending on the composition, if the Ga concentration in the thickness direction is varied, it is believed to be preferable to optimize the concentration distribution of the alkaline (-earth) metal according to the concentration distribution of Ga.

SUMMARY OF THE INVENTION

In view of the above-described circumstances, the present invention is directed to providing a photoelectric conversion device which has an concentration distribution of an alkaline (-earth) metal in the thickness direction in a photoelectric conversion layer being optimized according to a concentration distribution of Ga in the thickness direction in the photoelectric conversion layer, has less defects causing a loss in photoelectric conversion in the photoelectric conversion layer, and thus has high photoelectric conversion efficiency.

An aspect of the photoelectric conversion device of the invention is a photoelectric conversion device including:

a layered structure formed on a substrate, the layered structure including a first electrode (back electrode), a photoelectric conversion semiconductor layer for generating an electric current when it absorbs light, and a second electrode (translucent electrode),
wherein the photoelectric conversion semiconductor layer contains, as a main component, at least one compound semiconductor containing a group Ib element, at least two group IIIb elements including Ga, and a group VIb element, and contains one or two or more alkaline(-earth) metals,
wherein a concentration distribution of the alkaline (-earth) metal in a thickness direction in the photoelectric conversion semiconductor layer includes a valley position with a lowest concentration of the alkaline (-earth) metal and an area with a concentration of the alkaline(-earth) metal higher than the concentration at the valley position, the area being nearer to the substrate from the valley position,
wherein a concentration distribution of Ga in the thickness direction in the photoelectric conversion semiconductor layer includes a valley position with a lowest concentration of Ga and an area with a concentration of Ga higher than the concentration at the valley position, the area being nearer to the substrate from the valley position, and
wherein Expressions (1) and (2) below are satisfied:

$$1.0 \times 10^{-6} \leq A_N \ [\mathrm{mol/cc}] \leq 2.0 \times 10^{-5} \qquad (1)$$

and

$$1.0 \leq C_N/C_G \qquad (2)$$

where, with respect to the concentration distribution of the alkaline(-earth) metal in the thickness direction in the photoelectric conversion semiconductor layer, $A_N$ [mol/cc] represents the concentration of the alkaline(-earth) metal at the valley position and $B_N$ [mol/cc] represents the highest concentration of the alkaline (-earth) metal at a position nearer to the substrate from the valley position; with respect to the concentration distribution of Ga in the thickness direction in the photoelectric conversion semiconductor layer, $A_G$ [mol/cc] represents the concentration of Ga at the valley position and $B_G$ [mol/cc] represents the highest concentration of Ga at a position nearer to the substrate from the valley position; $C_N$ represents a ratio ($B_N/A_N$) between $A_N$ and $B_N$, and $C_G$ represents a ratio ($B_G/A_G$) between $A_G$ and $B_G$.

The "main component" is defined herein as a component that is contained at a content of at least 98% by mass, unless otherwise stated.

Measurement of the concentration distribution of the element in the thickness direction can be achieved using, for example, secondary ion mass spectroscopy (SIMS).

According to the invention, a photoelectric conversion device which has a concentration distribution of the alkaline (-earth) metal in the photoelectric conversion layer in the thickness direction that is optimized according to the concentration distribution of Ga in the thickness direction, has less defects causing a loss in photoelectric conversion in the photoelectric conversion layer, and thus has high photoelectric conversion efficiency can be provided.

In the invention, the amount of the alkaline(-earth) metal to be supplied and the state of diffusion thereof are optimized according to the concentration distribution of Ga in the thickness direction, and thus highly efficient photoelectric conversion devices can be provided in a stable manner.

BRIEF DESCRIPTION OF THE DRAWINGS

FIG. 1 is a sectional view illustrating the structure of a photoelectric conversion device according to a first embodiment of the present invention,

FIG. 2A is a sectional view illustrating the structure of a photoelectric conversion device according to a second embodiment of the invention,

FIG. 2B is a sectional view illustrating another aspect of the photoelectric conversion device according to the second embodiment of the invention,

FIG. 3 shows a relationship between lattice constant and bandgap of I-III-VI compound semiconductors,

FIG. 4 shows a SIMS spectrum of Example 1-1,

FIG. 5 shows a SIMS spectrum of Example 1-2,

FIG. 6 shows a SIMS spectrum of Example 1-3,

FIG. 7 shows a SIMS spectrum of Comparative Example 1-1,

FIG. 8 shows a SIMS spectrum of Example 2-1,

FIG. 9 shows a SIMS spectrum of Example 2-2, and

FIG. 10 shows a SIMS spectrum of Comparative Example 2-1.

DESCRIPTION OF THE PREFERRED EMBODIMENTS

*Photoelectric Conversion Device and Method for Producing the Photoelectric Conversion Device*

A photoelectric conversion device of the present invention includes a layered structure formed on a substrate, the layered structure including a first electrode (back electrode), a photoelectric conversion semiconductor layer for generating an electric current when it absorbs light, and a second electrode (translucent electrode), wherein the photoelectric conversion semiconductor layer contains, as a main component, at least one compound semiconductor (group I-III-VI semiconductor) containing a group Ib element, at least two group IIIb elements including Ga, and a group VIb element, and contains one or two or more alkaline(-earth) metals, and wherein the concentration distributions of the alkaline (-earth) metal and Ga in the photoelectric conversion semiconductor layer in the thickness direction are optimized.

The group I-III-VI semiconductor, which is the main component, may contain one or two or more group Ib elements and group VIb elements, respectively. The group I-III-VI semiconductor contains at least two group IIIb elements including Ga.

In view of providing a high light absorption rate and high photoelectric conversion efficiency, the main component of the photoelectric conversion semiconductor layer may be at least one compound semiconductor (S) which contains:

at least one group Ib element selected from the group consisting of Cu and Ag;

at least two group IIIb elements including Ga selected from the group consisting of Al, Ga and In; and
at least one group VIb element selected from the group consisting of S, Se and Te.

Examples of the compound semiconductor (S) may include:

Cu $(In_{1-x},Ga_x)S_2$, Cu$(In_{1-x}Ga_x)Se_2$ (CIGS), Cu$(In_{1-x}Ga_x)$ $(S,Se)_2$, Ag$(In_{1-x}Ga_x)S_2$ Ag$(In_{1-x}Ga_x)Se_2$, and Ag$(In_{1-x}Ga_x)$ $(S,Se)_2$.

The photoelectric conversion semiconductor layer may contain Cu$(In,Ga)S_2$, Cu$(In,Ga)Se_2$ (CIGS), or a sulfide-selenide thereof. The photoelectric conversion semiconductor layer may contain one or two or more of them. The CIGS, etc., are reported to have a high light absorption rate and high photoelectric conversion efficiency. Further, they are less susceptible to deterioration of efficiency due to exposure to light and have excellent durability.

The photoelectric conversion semiconductor layer contains an impurity to provide a desired semiconductor conductivity type. The impurity can be added to the photoelectric conversion semiconductor layer by diffusion from an adjacent layer and/or actively by doping.

In the photoelectric conversion semiconductor layer, the constituent elements and/or the impurity of the group I-III-VI semiconductor may have a distributed concentration, or the photoelectric conversion semiconductor layer may include layer areas having different types of semiconductivity, such as n-, p- and i-type areas.

In the CIGS system, when the Ga content in the photoelectric conversion layer has a distribution in the thickness direction, the width of the bandgap, the mobility of the carrier, etc., can be controlled, thereby achieving a design which provides high photoelectric conversion efficiency.

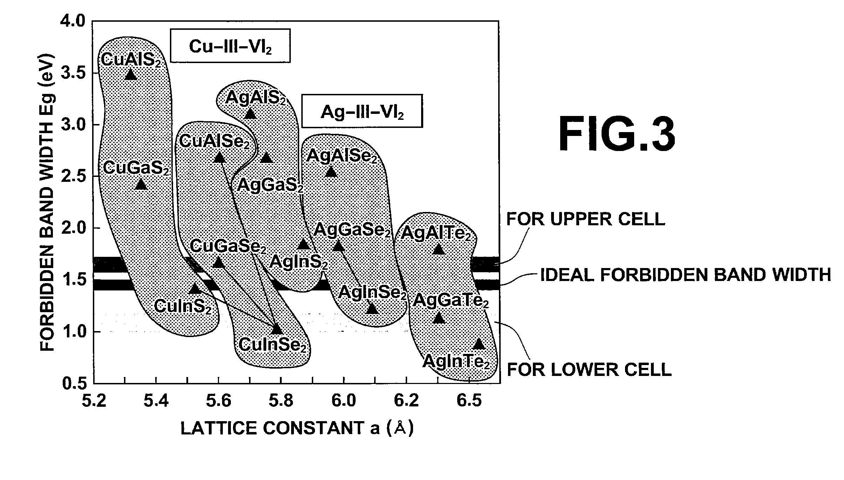

FIG. 3 shows a relationship between lattice constant and bandgap of typical I-III-VI compound semiconductors. It can be seen from FIG. 3 that various forbidden band widths (bandgaps) can be provided by varying the composition ratio. In the case of CIGS, for example, potential control in the range from 1.04 to 1.68 eV can be achieved by varying the concentration of Ga.

The photoelectric conversion semiconductor layer may contain any component other than the essential components and the impurity to provide a desired conductivity type as long as the properties thereof are not impaired.

The photoelectric conversion semiconductor layer may contain, for example, one or two or more semiconductors other than the group I-III-VI semiconductor. Examples of the semiconductors other than the group I-III-VI semiconductor may include: a semiconductor containing a group IVb element (group IV semiconductor), such as Si; a semiconductor containing a group IIIb element and a group Vb element (group III-V semiconductor), such as GaAs; and a semiconductor containing a group IIb element and a group VIb element (group II-VI semiconductor), such as CdTe.

In the photoelectric conversion device of the invention, the photoelectric conversion semiconductor layer contains one or two or more alkaline (-earth) metals. The alkaline (-earth) metal is said to serve to passivate defects causing a loss in photoelectric conversion efficiency, and it is known that a photoelectric conversion semiconductor layer containing the alkaline(-earth) metal has improved crystal properties, and thus has higher photoelectric conversion efficiency.

Examples of the alkali metal may include Li, Na, K, Rb and Cs. Examples of the alkaline-earth metal may include Be, Mg, Ca, Sr and Ba.

In a usual production method, the alkaline (-earth) metal in the photoelectric conversion semiconductor layer is supplied during formation of the photoelectric conversion semiconductor layer from the substrate or from at least one alkaline (-earth) metal supplying layer, which is provided between the substrate and the photoelectric conversion layer.

Among the above-listed alkaline (-earth) metals, at least one alkali metal selected from Na, K, Rb, and Cs may be used in view of chemical stability, ease of emission of the alkaline (-earth) metal from the substrate or the alkaline(-earth) metal supplying layer when heated, and high effect of improvement of crystal properties of the photoelectric conversion semiconductor layer. Among them, Na and/or K, in particular, Na may be used.

Since the alkaline (-earth) metal is supplied and diffused into the photoelectric conversion semiconductor layer from the substrate or the alkaline (-earth) metal layer, the alkaline (-earth) metal in the photoelectric conversion semiconductor layer usually has a distribution in the thickness direction.

Defects in the photoelectric conversion layer vary depending on the composition. Therefore, if the concentration of Ga in the thickness direction is varied, it is believed to be preferable to optimize the concentration distribution of the alkaline(-earth) metal according to the concentration distribution of Ga in the thickness direction. However, no detailed study in this point of view has been reported in prior art.

The photoelectric conversion device of the invention includes:

a concentration distribution of the alkaline(-earth) metal in the photoelectric conversion semiconductor layer in the thickness direction that includes a valley position with the lowest concentration of the alkaline(-earth) metal and an area nearer to the substrate side from the valley position with a higher concentration of the alkaline (-earth) metal than the concentration at the valley position; and

a concentration distribution of Ga in the photoelectric conversion semiconductor layer in the thickness direction that includes a valley position with the lowest concentration of Ga and an area nearer to the substrate side from the valley position with a higher concentration of Ga than the concentration at the valley position, where Expressions (1) and (2) below are satisfied:

$$1.0 \times 10^{-6} \leq A_N \, [\text{mol/cc}] \leq 2.0 \times 10^{-5} \qquad (1)$$

and

$$1.0 \leq C_N/C_G \qquad (2),$$

where, with respect to the concentration distribution of the alkaline(-earth) metal in the thickness direction in the photoelectric conversion semiconductor layer, $A_N$ [mol/cc] represents the concentration of the alkaline(-earth) metal at the valley position and $B_N$ [mol/cc] represents the highest concentration of the alkaline (-earth) metal at a position nearer to the substrate from the valley position; with respect to the concentration distribution of Ga in the thickness direction in the photoelectric conversion semiconductor layer, $A_G$ [mol/cc] represents the concentration of Ga at the valley position and $B_G$ [mol/cc] represents the highest concentration of Ga at a position nearer to the substrate from the valley position; $C_N$ represents a ratio ($B_N/A_N$) between $A_N$ and $B_N$, and $C_G$ represents a ratio ($B_G/A_G$) between $A_G$ and $B_G$

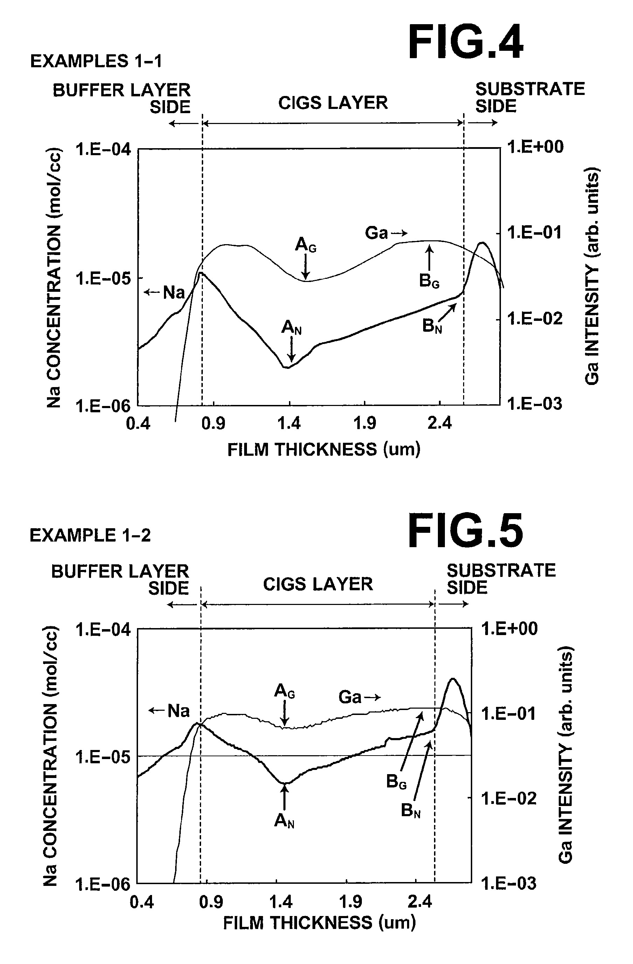

See FIGs. 4-6, 8 and 9 with respect to Examples, which will be described later, for examples of the concentration distributions of the alkaline (-earth) metal and Ga in the photoelectric conversion layer in the thickness direction that satisfy this specification of the invention.

The film formation method used in the invention to form the photoelectric conversion semiconductor layer is not particularly limited.

Examples of known film formation methods for forming the CIGS layer include (1) multi-source co-evaporation, (2) selenization process, (3) sputtering, (4) hybrid sputtering and (5) mechanochemical processing.

(1) As the multi-source co-evaporation, a three-step process (J. R. Tuttle et al., "The Performance of Cu(In, Ga)Se2-Based Solar Cells in Conventional and Concentrator Applications", Mat. Res. Soc. Symp. Proc. Vol. 426, pp. 143-151, 1996, etc.) and a co-evaporation process of EC Group (L. Stolt et al., "THIN FILM SOLAR CELL MODULES BASED ON CU(IN,GA)SE2 PREPARED BY THE COEVAPORATION METHOD", Proc. 13th EUPVSEC, pp. 1451-1455, 1995, etc.) are known.

In the three-step process, first, In, Ga and Se are simultaneously deposited at a substrate temperature of 300 °C in high vacuum, then, the temperature is raised to 500 to 560 °C and Cu and Se are simultaneously deposited, and then, In, Ga and Se are simultaneously deposited again. In the co-evaporation process of the EC Group, Cu-excess CIGS is deposited in the early stage of the vapor deposition, and In-excess CIGS is deposited in the later stage of the vapor deposition.

As improved methods for improving the crystal properties of the CIGS layer:

(a) a method using ionized Ga (H. Miyazaki et al., "Growth of high-quality CuGaSe2 thin films using ionized Ga precursor", phys. stat. sol. (a), Vol. 203, pp. 2603-2608, 2006, etc);
(b) a method using cracked Se (Proceedings of the 68th lecture meeting of The Japan Society of Applied Physics (2007 Autumn, Hokkaido Institute of Technology), 7P-L-6, etc.);
(c) a method using radicalized Se (Proceedings of the 54th lecture meeting of The Japan Society of Applied Physics (2007 Spring, Aoyama Gakuin University) 29P-ZW-10, etc.);
(d) a method using a photoexcitation process (Proceedings of the 54th lecture meeting of The Japan Society of Applied Physics (2007 Spring, Aoyama Gakuin University) 29P-ZW-14, etc.), and the like, are known.

(2) The selenization process is also referred to as a two-step process, where, first, a metal precursor of a layered film, such as Cu layer / In layer or (Cu-Ga) layer / In layer, is formed through sputtering, vapor deposition, electrodeposition, or the like, and the formed metal precursor is heated to a temperature of around 450 to 550 °C in selenium vapor or hydrogen selenide to form a selenium compound, such as $Cu(In_{1-x}Ga_x)Se_2$ via a thermal diffusion reaction. This method is referred to as a vapor-phase selenization process. Besides this method, a solid-phase selenization process may be used, where solid-phase selenium is deposited on a metal precursor film, and selenization is achieved through a solid-phase diffusion reaction with the solid-phase selenium serving as a selenium source.

Among the selenization processes, a method where a certain ratio of selenium is mixed in advance in the metal precursor film to avoid rapid volume expansion during selenization (T. Nakada et al., "CuInSe2-based solar cells by Se-vapor selenization from Se-containing precursors", Solar Energy Materials and Solar Cells, Vol. 35, pp. 209-214, 1994, etc.) and a method where selenium is disposed between thin metal layers (for example, metal layers are formed in the order of Cu layer / In layer /Se layer / ... / Cu layer /In layer / Se layer) to form a multi-layered precursor film (T. Nakada et al., "THIN FILMS OF CuInSe2 PRODUCED BY THERMAL ANNEALING OF MULTILAYERS WITH ULTRA-THIN STACKED ELEMENTAL LAYERS", Proceedings of the 10th European Photovoltaic Solar Energy Conference (EU PVSEC), pp. 887-890, 1991, etc.) are known.

Further, as a method for forming a graded bandgap CIGS layer, a method is known, where a Cu-Ga alloy film is deposited first, an In film is deposited thereon, and, when these films are selenized, a gradient Ga concentration in the film thickness direction is achieved using natural thermal diffusion (K. Kushiya et. al, Tech. Digest 9th Photovoltaic Science and Engineering Conf. Miyazaki, 1996 (Intn. PVSEC-9, Tokyo, 1996), p.149, etc.)

(3) As the sputtering:

a method using a $CuInSe_2$ polycrystal target;
a two-source sputtering process using a $Cu_2Se$ target and an $In_2Se_3$ target and $H_2Se/Ar$ mixed gas as the sputtering gas (J.H. Ermer et al., "CdS/CuInSe2 JUNCTIONS FABRICATED BY DC MAGNETRON SPUTTERING OF Cu2Se AND In2Se3", Proceedings of the 18th IEEE Photovoltaic Specialists Conference, pp.1655-1658, 1985, etc.); and
a three-source sputtering process which carries out sputtering using a Cu target, an In target and a Se or CuSe target in Ar gas (T. Nakada et al., "Polycrystalline CuInSe2 Thin Films for Solar Cells by Three-Source Magnetron Sputtering", Japanese Journal of Applied Physics, Vol. 32, Part 2, No. 8B, pp. L1169-L1172, 1993, etc.) are known.

(4) As the hybrid sputtering, a hybrid sputtering process where Cu and In are DC sputtered using the above-described sputtering process and Se is vapor deposited (T. Nakada et al., "Microstructural Characterization for Sputter-Deposited CuInSe2 Films and Photovoltaic Devices", Japanese Journal of Applied Physics, Vol. 34, Part 1, No. 9A, pp. 4715-4721, 1995, etc.) is known.

(5) In the mechanochemical processing, starting materials according to the composition of CIGS are put in a planetary ball mill and the materials are mixed using mechanical energy to provide a CIGS powder. Then, the mixed material is applied on the substrate using a screen printing process and annealed to provide a CIGS film (T. Wada et al., "Fabrication of Cu(In,Ga)Se2 thin films by a combination of mechanochemical and screen-printing/sintering processes", physica status solidi (a), Vol. 203, No. 11, pp. 2593-2597, 2006, etc.)

(6) Other film formation methods for forming the CIGS film may include screen printing, close-spaced sublimation, MOCVD and spraying. For example, a particle film containing the group Ib element, the group IIIb element and the group VIb element may be formed on the substrate using screen printing or spraying, and pyrolysis of the particle film may be carried out (the pyrolysis may be carried out in an atmosphere of the group VIb element) to provide a crystal having a desired composition (see Japanese Unexamined Patent Publication Nos. 9(1997)-074065, 9(1997)-074213, etc.)

In Patent Document 1 mentioned in the BACKGROUND ART section, the CIGS layer is formed using the selenization process, which is a common process for forming the CIGS layer. The concentrations of Na and Ga in the photoelectric conversion semiconductor layer in the thickness direction are the highest at a surface facing the second electrode (translucent electrode), once decrease toward the first electrode (back electrode) and then increase to be constant at a level lower than the concentrations at the surface facing the second electrode (translucent electrode). The concentration distributions of Na and Ga in the thickness direction disclosed in Patent Document 1, each of which includes an area where the concentration is constant, are unique to the selenization process.

It is preferable that the concentration distribution of Ga in the photoelectric conversion semiconductor layer in the thickness direction shows a valley-shaped distribution, where the concentration gradually decreases from the second electrode (translucent electrode) side, and then, gradually increases toward the substrate side. This pattern is called a double grading type, and is known to provide higher efficiency than a single grading type. For the single grading structure and the double grading structure, see, for example, T. Dullweber et al., "A new approach to high-efficiency solar cells by band gap grading in Cu(In,Ga)Se2 chalcopyrite semiconductors", Solar Energy Materials and Solar Cells, Vol. 67, pp. 145-150, 2001.

In typical film formation of the CIGS layer having the double grading structure using the three-step process, first, InSe or InGaSe is vapor deposited at a relatively low temperature (for example, around 400 °C), and then, the substrate temperature is raised (for example, around 525 °C) to vapor deposit CuSe, and finally, InGaSe is vapor deposited. A desired Ga concentration distribution can be provided by controlling the target composition and film formation conditions, such as the substrate temperature during each step.

In the case where the photoelectric conversion layer, such as the CIGS layer, is formed using the vapor deposition process, such as the three-step process, where a plurality of metal elements are vapor deposited in a plurality of steps, the concentration distribution of the alkaline(-earth) metal in the photoelectric conversion semiconductor layer in the thickness direction often exhibits a valley-shaped distribution, where the concentration gradually decreases from the second electrode side, and then gradually increases toward the substrate side (see FIGs. 4 to 6, 8 and 9 with respect to Examples, which will be described later).

This is because that the alkaline(-earth) metal is supplied from the substrate side, and therefore the concentration of the alkaline (-earth) metal is higher at the substrate side and the concentration gradually decreases in the thickness direction; however, the alkaline (-earth) metal accumulates in the vicinity of the surface facing the second electrode (translucent electrode) and the concentration increases there.

Further, in the case where the photoelectric conversion layer, such as the CIGS layer, having the double grading structure is formed using the vapor deposition process, such as the three-step process, where a plurality of metal elements are vapor deposited in a plurality of steps, the concentration distribution of Ga in the photoelectric conversion semiconductor layer in the thickness direction and the concentration distribution of the alkaline(-earth) metal in the photoelectric conversion semiconductor layer have similar apparent increase-decrease behaviors of the concentration.

Therefore, by optimizing the concentration distribution of the alkaline (-earth) metal in the thickness direction according to the concentration distribution of Ga in the thickness direction, a photoelectric conversion device having less defects causing a loss in photoelectric conversion in the photoelectric conversion layer and having high photoelectric conversion efficiency can be provided.

It should be noted that the concentration distributions of the alkaline(-earth) metal and Ga in the photoelectric conversion layer in the thickness direction of the photoelectric conversion device of the invention is not limited to the above-described pattern. The change of the concentration from the surface facing the second electrode (translucent electrode) to the valley position may not be monotonous decrease, and the change of the concentration from the valley position to the surface facing the substrate may not be monotonous increase, as long as the valley position with the lowest concentration of the alkaline (-earth) metal and the area nearer to the substrate from the valley position with a higher concentration of the alkaline (-earth) metal than the concentration at the valley position are present, and the valley position with the lowest concentration of Ga and the area nearer to the substrate side from the valley position with a higher concentration of Ga than the concentration at the valleyposition are present. Further, the valley position of the concentration of the alkaline (-earth) metal and the valley position of the concentration of Ga may be at the same position or at different positions.

Although the concentration distribution specified in the invention is easier to be achieved when the film formation is achieved using a vapor deposition process, such as the three-step process, where a plurality of metal elements are deposited in a plurality of steps, the concentration distribution specified in the invention might also be achieved using any other film formation method.

In the invention, the concentration distributions of the alkaline (-earth) metal and Ga in the photoelectric conversion layer in the thickness direction satisfy Expressions (1) and (2) below:

$$1.0 \times 10^{-6} \leq A_N \ [\text{mol/cc}] \ \leq 2.0 \times 10^{-5} \qquad (1)$$

and

$$1.0 \leq C_N/C_G \qquad (2),$$

where, with respect to the concentration distribution of the alkaline (-earth) metal in the thickness direction in the photoelectric conversion semiconductor layer, $A_N$ [mol/cc] represents the concentration of the alkaline(-earth) metal at the valley position and $B_N$ [mol/cc] represents the highest concentration of the alkaline (-earth) metal at a position nearer to the substrate from the valley position; with respect to the concentration distribution of Ga in the thickness direction in the photoelectric conversion semiconductor layer, $A_G$ [mol/cc] represents the concentration of Ga at the valley position and $B_G$ [mol/cc] represents the highest concentration of Ga at a position nearer to the substrate from the valley position; $C_N$ represents a ratio ($B_N/A_N$) between $A_N$ and $B_N$, and $C_G$ represents a ratio ($B_G/A_G$) between $A_G$ and $B_G$.

In the photoelectric conversion semiconductor layer that satisfies the above specification, defects causing a loss in photoelectric conversion are satisfactorily passivated across the thickness direction, and thus high photoelectric conversion efficiency can be provided in a stable manner.

If the amount of the alkaline (-earth) metal supplied from the substrate side is lower and other film formation conditions are the same, the concentration $A_N$ of the alkaline (-earth) metal at the valley position tends to become lower.

If the amount of the alkaline (-earth) metal supplied from the substrate side is higher, the concentration $A_N$ of the alkaline (-earth) metal at the valley position tends to become higher.

If the concentration $A_N$ of the alkaline (-earth) metal at the valley position is less than $1.0 \times 10^{-6}$, areas where the defects causing a loss in photoelectric conversion are not satisfactorily passivated may be left, and it is difficult to provide high photoelectric conversion efficiency in a stable manner.

If the concentration $A_N$ of the alkaline (-earth) metal at the valley position is higher than $2.0 \times 10^{-5}$, this means that an excessive amount of the alkaline (-earth) metal is supplied from the substrate side. In this case, a high amount of the alkaline(-earth) metal accumulates at the substrate side, and this may often lead to peeling between the substrate and the photoelectric conversion layer. Thus, it is difficult to provide high photoelectric conversion efficiency.

If the amount of the alkaline (-earth) metal supplied from the substrate side is lower and other film formation conditions are the same, it is difficult to provide variation in the concentration of the alkaline (-earth) metal in the thickness direction and the ratio $B_N/A_N$ tends to become smaller. If the amount of the alkaline (-earth) metal supplied from the substrate side is higher, it is easier to provide variation in the concentration of the alkaline (-earth) metal in the thickness direction and the ratio $B_N/A_N$ tends to become larger.

Further, in the three-step process, if diffusion of Ga in the third step during the film formation is insufficient, the change of the Ga concentration tends to become larger in the thickness direction, resulting in a larger $B_G/A_G$. On the other hand, if the diffusion of Ga is sufficient, the change of the Ga concentration tends to become smaller, resulting in a smaller $B_G/A_G$.

If the $C_N/C_G$ is less than 1.0, the grading of Na is small relative to the grading of Ga, and areas where defects due to Ga are not passivated are left. Thus it is difficult to provide high photoelectric conversion efficiency in a stable manner.

As shown in Examples, which will be described later, the present inventor actually produced photoelectric conversion devices which satisfy the specification: $2.0 \times 10^{-6} \leq A_N$ [mol/cc] $\leq 8.0 \times 10^{-6}$ and $1.3 \leq C_N/C_G \leq 2.1$.

The present inventor collected data about the three-step process disclosed in research papers, etc., and found that the value of $C_N/C_G$ does not become extremely large unless the three-step process is intentionally modified or a large excess amount of Na is provided. Therefore, no upper limit of the value of $C_N/C_G$ is defined in the invention. As mentioned above, films with a value of $C_N/C_G$ ranging from 1.3 to 2.1 were obtained in the Examples. Usually, the value of $C_N/C_G$ does not exceed 3.0.

The concentration distribution of the alkaline (-earth) metal in the photoelectric conversion semiconductor layer in the thickness direction can be controlled by controlling the concentration of the alkaline(-earth) metal in the substrate or the alkaline(-earth) metal supplying layer and diffusion thereof.

The diffusion of the alkaline (-earth) metal can be controlled by controlling the structure of a layer disposed between the substrate or the alkaline(-earth) metal supplying layer, which supplies the alkaline(-earth) metal, and the photoelectric conversion semiconductor layer, the composition of the photoelectric conversion semiconductor layer, the film formation method used, film formation conditions, such as temperature and pressure, etc.

In the aspect where the substrate supplying the alkaline(-earth) metal is used or the alkaline(-earth) metal supplying layer is provided between the substrate and the first electrode (back electrode), the alkaline (-earth) metal is supplied to the photoelectric conversion semiconductor layer through the first electrode (back electrode).

In this aspect, the diffusion of the alkaline(-earth) metal can be controlled, for example, by controlling film formation conditions for the first electrode (back electrode) to control the layer structure of the first electrode (back electrode).

A typical main component of the first electrode (back electrode) is Mo. A Mo electrode is a film having a crystal structure formed by a number of columnar crystals extending in a direction which is not parallel to the surface of the substrate. With the columnar crystal structure, the degree of diffusion of the alkaline (-earth) metal varies depending on the size of gap between adjacent columnar crystals under the same thickness condition. Therefore, the diffusion of the alkaline(-earth) metal can be controlled by controlling film formation conditions of the Mo electrode to control the column diameter of the columnar crystals and the gap between adjacent columnar crystals.

In the case where the photoelectric conversion semiconductor layer is formed through a vapor deposition process where a plurality of metal elements are deposited in a plurality of steps, the photoelectric conversion semiconductor layer may be formed at a substrate temperature in the range from 350 to 550 °C, in view of providing better diffusion of the alkaline (-earth) metal and crystal properties of the photoelectric conversion layer to provide higher photoelectric conversion efficiency. The "substrate temperature during formation of the photoelectric conversion layer" herein refers to the highest substrate temperature during the formation of the photoelectric conversion layer, unless otherwise stated.

As described above, the invention is achieved by optimizing the concentration distribution of the alkaline (-earth) metal in the thickness direction in the photoelectric conversion layer according to the concentration distribution of Ga in the thickness direction.

According to the invention, the concentration distribution of the alkaline(-earth) metal in the thickness direction in the photoelectric conversion layer is optimized according to the concentration distribution of Ga in the thickness direction, thereby providing a photoelectric conversion device which has less defects causing a loss in photoelectric conversion and has high photoelectric conversion efficiency.

In the invention, the amount of the alkaline(-earth) metal to be supplied and the state of diffusion thereof are optimized according to the concentration distribution of Ga in the thickness direction, thereby providing highly efficient photoelectric conversion devices in a stable manner.

*First Embodiment of Photoelectric Conversion Device*

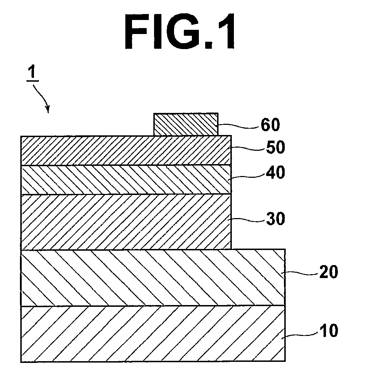

The structure of a photoelectric conversion device according to a first embodiment of the invention is described with reference to the drawings. FIG. 1 is a schematic sectional view of the photoelectric conversion device. For ease of visual recognition, the elements shown in the drawings are not to scale.

The photoelectric conversion device 1 shown in FIG. 1 includes a substrate 10 containing an alkaline(-earth) metal, and a first electrode (back electrode) 20, a photoelectric conversion semiconductor layer 30, a buffer layer 40, a translucent second electrode (translucent electrode) 50 and a grid electrode 60, which are formed on the substrate 10 in this order.

(Substrate)

In this embodiment, the content of the alkaline (-earth) metal in the substrate 10 is enough to supply a sufficient amount of the alkaline(-earth) metal to the photoelectric conversion layer 30 during formation of the photoelectric conversion layer 30. An example of the substrate is a soda lime glass substrate.

(Photoelectric Conversion Semiconductor Layer)

The photoelectric conversion semiconductor layer 30 contains, as a main component, at least one compound semiconductor (group I-III-VI semiconductor) containing a group Ib element, at least two group IIIb elements including Ga, and a group VIb element, and contains one or two or more alkaline(-earth) metals,
wherein the concentration distribution of the alkaline(-earth) metal in the photoelectric conversion semiconductor layer in the thickness direction includes a valley position with the lowest concentration of the alkaline (-earth) metal and an area nearer to the substrate side from the valley position with a higher concentration of the alkaline(-earth) metal than the concentration at the valley position, and
the concentration distribution of Ga in the photoelectric conversion semiconductor layer in the thickness direction includes a valley position with the lowest concentration of Ga and an area nearer to the substrate side from the valley position with a higher concentration of Ga than the concentration at the valley position, and
wherein Expressions (1) and (2) below are satisfied:

$$1.0 \times 10^{-6} \leq A_N \ [\mathrm{mol/cc}] \leq 2.0 \times 10^{-5} \qquad (1)$$

and

$$1.0 \leq C_N/C_G \qquad (2),$$

where, with respect to the concentration distribution of the alkaline (-earth) metal in the thickness direction in the photoelectric conversion semiconductor layer, $A_N$ [mol/cc] represents the concentration of the alkaline(-earth) metal at the valley position and $B_N$[mol/cc] represents the highest concentration of the alkaline (-earth) metal at a position nearer to the substrate from the valley position; with respect to the concentration distribution of Ga in the thickness direction in the photoelectric conversion semiconductor layer, $A_G$ [mol/cc] represents the concentration of Ga at the valley position and $B_G$ [mol/cc] represents the highest concentration of Ga at a position nearer to the substrate from the valley position; $C_N$ represents a ratio ($B_N/A_N$) between $A_N$ and $B_N$, and $C_G$ represents a ratio ($B_G/A_G$) between $A_G$ and $B_G$.

(Electrode, Buffer Layer)

The first electrode 20 and the second electrode 50 are made of a conductive material. The second electrode 50 provided at the light-incident side needs to be translucent.

The main component of the first electrode (back electrode) 20 is not particularly limited. Examples thereof include Mo, Cr, W and combinations thereof, in particular, Mo. The thickness of the first electrode (back electrode) 20 is not particularly limited; however, it may be in the range from 0.3 to 1.0 $\mu$m.

The main component of the second electrode (translucent electrode) 50 is not particularly limited, and examples thereof include ZnO, ITO (indium tin oxide), $SnO_2$ and combinations thereof. The thickness of the second electrode (translucent electrode) 50 is not particularly limited; however, it may be in the range from 0.6 to 1.0 $\mu$m.

The first electrode 20 and/or the second electrode 50 may have a single-layer structure or a layered structure, such as a double-layer structure.

Examples of the film formation method used to form the first electrode 20 and the second electrode 50 include vapor-phase film formation processes, such as electron beam vapor deposition and sputtering.

The main component of the buffer layer 40 is not particularly limited, and examples thereof include CdS, ZnS, ZnO, ZnMgO, ZnS (O, OH) and combinations thereof. The thickness of the buffer layer 40 is not particularly limited; however, it may be in the range from 0.03 to 0.1 $\mu$m.

An example combination of compositions is: Mo back electrode / CIGS photoelectric conversion layer / CdS buffer layer / ZnO translucent electrode.

The conductivity types of the layers from the photoelectric conversion layer 30 to the second electrode (translucent electrode) 50 are not particularly limited. Typically, the photoelectric conversion layer 30 may be a p-layer, the buffer layer 40 may be an n-layer (such as an n-CdS layer), and the second electrode (translucent electrode) 50 may be an n-layer (such as an n-ZnO layer) or a multi-layer structure of an i-layer and an n-layer (such as an i-ZnO layer and an n-ZnO layer). With these conductivity types, it is believed that a p-n junction or a p-i-n junction is formed between the photoelectric conversion layer 30 and the second electrode (translucent electrode) 50. Further, it is believed that, when the buffer layer 40 provided on the photoelectric conversion layer 30 is made of CdS, Cd diffuses to form an n-layer on the surface of the photoelectric conversion layer 30, and a p-n junction is formed in the photoelectric conversion layer 30. An i-layer might be provided under the n-layer in the photoelectric conversion layer 30 to form a p-i-n junction in the photoelectric conversion layer 30.

A window layer may be provided between the buffer layer 40 and the second electrode (translucent electrode) 50.

(Grid Electrode)

The main component of the grid electrode 60 is not particularly limited, and an example thereof is Al. The film thickness of the grid electrode 60 is not particularly limited; however, it may be in the range from 0.1 to 3 $\mu$m.

The photoelectric conversion device 1 may include any optional layer other than the above-described layers, as necessary. For example, an adhesion layer (buffer layer) to increase adhesion between the layers may be provided, as necessary, between the substrate 10 and the first electrode (back electrode) 20, and/or between the first electrode (back electrode) 20 and the photoelectric conversion layer 30. Further, an alkali barrier layer for suppressing diffusion of alkali ions may be provided, as necessary, between the substrate 10 and the first electrode (back electrode) 20. For the alkali barrier layer, see U.S. Patent No. 5,626,688.

The structure of the photoelectric conversion device 1 of this embodiment is as described above.

The photoelectric conversion device 1 of this embodiment has the optimized concentration distributions of the alkaline(-earth) metal and Ga in the thickness direction in the photoelectric conversion semiconductor layer 30.

According to this embodiment, the concentration distributions of the alkaline(-earth) metal and Ga in the thickness direction in the photoelectric conversion semiconductor layer 30 are optimized, thereby providing the photoelectric conversion device 1 which has less defects causing a loss in photoelectric conversion in the photoelectric conversion layer 30 and has high photoelectric conversion efficiency.

In this embodiment, the amount of the alkaline (-earth) metal to be supplied and the state of diffusion thereof are optimized, thereby providing the highly efficient photoelectric conversion device 1 in a stable manner.

*Second Embodiment of Photoelectric Conversion Device*

The structures of photoelectric conversion devices according to a second embodiment of the invention is described with reference to the drawings. FIGs. 2A and 2B are schematic sectional views of the photoelectric conversion devices. For ease of visual recognition, the elements shown in the drawings are not to scale. Elements which are the same as those in the first embodiment are denoted by the same reference numerals, and descriptions thereof are omitted.

A photoelectric conversion device 2A shown in FIG. 2A includes a substrate 11, and an alkaline(-earth) metal supplying layer 70, the first electrode (back electrode) 20, the photoelectric conversion layer 30, the buffer layer 40, the second electrode (translucent electrode) 50 and the grid electrode 60, which are formed on the substrate 11 in this order.

A photoelectric conversion device 2B shown in FIG. 2B includes the substrate 11, and the first electrode (back electrode) 20, the alkaline(-earth) metal supplying layer 70, the photoelectric conversion layer 30, the buffer layer 40, the second electrode (translucent electrode) 50 and the grid electrode 60, which are formed on the substrate 11 in this order.

The difference between the photoelectric conversion device 2A and the photoelectric conversion device 2B lies only in the position of the alkaline (-earth) metal supplying layer 70, and the other features are the same.

(Substrate)

In this embodiment, the substrate 11 may not contain the alkaline (-earth) metal enough to supply a sufficient amount of the alkaline(-earth) metal to the photoelectric conversion layer 30 during formation of the photoelectric conversion layer 30, and therefore, any substrate may be used as the substrate 11.

Examples of the substrate 11 may include:

a glass substrate with small alkaline (-earth) metal content, such as white float glass;
a metal substrate, such as stainless steel, with an insulating film formed on the surface thereof;
an anodized substrate having an anodized film, which contains $Al_2O_3$ as the main component, formed on at least one side of an Al substrate, which contains Al as the main component;
an anodized substrate having an anodized film, which contains $Al_2O_3$ as the main component, formed on at least one side of a composite substrate made of a Fe material, which contains Fe as the main component, and an Al material, which contains Al as the main component, combined on at least one side of the Fe material;
an anodized substrate having an anodized film, which contains $Al_2O_3$ as the main component, formed on at least one side of a substrate made of a Fe material, which contains Fe as the main component, and an Al film, which contains Al as the main component, formed on at least one side of the Fe material; and
a resin substrate, such as polyimide. Any substrate may be used as the substrate 11.

The "main component" of the Al material, the Al film or the anodized film is defined herein as a component that is contained at a content of at least 98% by mass, unless otherwise stated. The "main component" of the Fe material is defined herein as a component that is contained at a content of at least 60% by mass, unless otherwise stated.

(Alkaline(-Earth) Metal Supplying Layer)

The alkaline(-earth) metal compound contained in the alkaline (-earth) metal supplying layer 70 may be an organic compound or an inorganic compound.

Examples of the alkali metal compound include: inorganic salts, such as sodium fluoride, potassium fluoride, sodium sulfide, potassium sulfide, sodium selenide, potassium selenide, sodium chloride and potassium chloride; and organic salts, such as a sodium or potassium salt of an organic acid, such as a polyacid.

Examples of the alkaline-earth metal compound include: inorganic salts, such as calcium fluoride, magnesium fluoride, calcium sulfide, magnesium sulfide and calcium selenide; and organic salts, such as a magnesium or calcium salt of an organic acid, such as a polyacid.

The "polyacid" herein includes heteropolyacid.

Among the examples of the compound listed above, an alkaline (-earth) metal salt of a polyacid may in particular be used. This type of compound is chemically stable and can form the alkaline (-earth) metal supplying layer 70 which is not easily peeled off. Although this type of compound is chemically stable, it decomposes when heated and efficiency emits the alkaline(-earth) metal, thereby providing the photoelectric conversion layer 30 with high conversion efficiency.

An example of polyacid is poly-oxoacid.

Examples of poly-oxoacid include tungstophosphoric acid, tungstosilicic acid, molybdophosphoric acid, molybdosilicic acid, vanadic acid, tungstic acid, low-valent niobic acid, low-valent tantalic acid, titanic acid having a tunnel structure, and molybdic acid.

Specific examples thereof include: α-12-tungstophosphoric acid, α-12-tungstosilicic acid, α-12-molybdophosphoric acid, α-12-molybdosilicic acid, 18-tungsto-2-phosphoric acid, 18-molybdo-2-phosphoric acid, α-11-tungstophosphoric acid, α-11-tungstosilicic acid, α-11-molybdophosphoric acid, α-11-tungstophosphoric acid, γ-10-tungstosilicic acid, A-α-9-tungstophosphoric acid, A-α-9-tungstosilicic acid, A-α-9-molybdophosphoric acid, A-α-9-molybdosilicic acid, decavanadic acid, orthovanadic acid, decatungstic acid, octa-peroxo-4-tungstophosphoric acid, hexa-titanic acid, octa-titanic acid, ramsdellite-type titanic acid, hollandite-type titanic acid deca-molybdic acid and huge molybdenum cluster.

Among the above-listed examples, molybdic acid and/or tungstic acid, in particular, molybdic acid may be used.

Examples of sodium molybdate include: $Na_2MO_2O_7$, $Na_6MO_7O_{24}$, $Na_2Mo_{10}O_{31}$, and $Na_{15}[Mo_{154}O_{462}H_{14}(H_2O)_{70}]_{0.5}[Mo_{152}O_{457}H_{14}(H_2O)_{68}]_{0.5}$. The similar types of salts can be listed as examples for the other alkaline(-earth) metals.

Sodium molybdate can be provided in the form of a thin layer by adjusting pH of a solution containing a molybdic acid and/or an alkali metal salt of a molybdic acid, such as $Na_2[MoO_4]$ or $MoO_3$, to a necessary pH value using an alkaline agent, such as nitric acid or sodium hydroxide, and then, applying the solution by spin coating, or the like, on the substrate 11 with the first electrode (back electrode) 20 formed thereon and heat drying the solution. The temperature for heat dry is not particularly limited, and may, for example, be about 200 °C.

The film formation may also be achieved by vapor-phase deposition, such as PVD (physical vapor-phase deposition) or CVD (chemical vapor-phase deposition), with using an alkali metal salt of molybdic acid, which has been synthesized and isolated in advance, as a vapor source. Examples of PVD include sputtering and vapor deposition.

It should be noted that, although there are many polyacids that contain a group VIII metal, such as Fe, or Mn, if this type of metal diffuses into the CIGS layer, or the like, the metal forms the recombination center and causes inefficiency, and such a situation is not preferred. Further, phosphoric acid-based polyacids are not preferred because of high hygroscopicity.

The concentration of the alkaline(-earth) metal in the alkaline(-earth) metal supplying layer 70 is not particularly limited, as long as the level thereof is enough to supply a sufficient amount of the alkaline (-earth) metal to the photoelectric conversion layer 30.

The thickness of the alkaline(-earth) metal supplying layer 70 is not particularly limited, as long as the level thereof is enough to supply a sufficient amount of the alkaline (-earth) metal to the photoelectric conversion layer 30. However, the thickness of the alkaline(-earth) metal supplying layer 70 may be in the range from 100 to 200 nm.

The layer structures (such as composition, thickness, etc.) of the layers other than the substrate 11 and the alkaline (-earth) metal supplying layer 70 are the same as those in the first embodiment, and descriptions thereof are omitted.

The invention is also applicable to the photoelectric conversion devices 2A and 2B of the second embodiment. According to this embodiment, similarly to the first embodiment, the concentration distributions of the alkaline(-earth) metal and Ga in the photoelectric conversion layer 30 in the thickness direction are optimized, thereby providing the photoelectric conversion devices 2A and 2B which have less defects causing a loss in photoelectric conversion in the photoelectric conversion layer 30 and have high photoelectric conversion efficiency.

*Solar Battery*

The photoelectric conversion devices 1, 2A and 2B are preferably applicable to solar batteries, etc. A solar battery can be formed by attaching a cover glass, a protective film, etc., to the photoelectric conversion device 1, 2A or 2B, as necessary.

(Modification)

The invention is not limited to the above-described embodiments, and may be modified as appropriate without departing from the spirit and scope of the invention.

EXAMPLES

Examples according to the invention and comparative examples are described.

(Examples 1-1 to 1-3)

As the substrate, a soda lime glass substrate (SLG) was prepared, and a Mo electrode having a size of 3 cm $\times$ 3 cm was formed on the substrate through RF sputtering. The Mo sputtering pressure was 0.3 Pa, and the film thickness of Mo was 0.8 $\mu$m.

A CIGS layer was formed on the above-described substrate using the three-step process. In these Examples, film formation was carried out with using a disk-shaped high-purity Cu target (99.9999% purity), a disk-shaped high-purity In target (99.9999% purity), a disk-shaped high-purity Ga target (99.999% purity), and a disk-shaped high purity Se target (99.999% purity). The substrate temperature was monitored using a chromel-alumel thermocouple.

First, a main vacuum chamber was vacuumed to $1.0 \times 10^{-6}$ Torr ($1.3 \times 10^{-4}$ Pa), and high-purity argon gas (99.999%) was introduced into the vacuum chamber and the pressure was controlled to $3.0 \times 10^{-2}$ Torr (4.0 Pa) with a variable leak valve. In the first step, film formation of In, Ga and Se was carried out at the substrate temperature of 350 °C. In the second step, film formation of Cu and Se was carried out at the highest substrate temperature of 450 °C (Example 1-1), 500 °C (Example 1-2), or 530 °C (Example 1-3). In the third step, film formation of In, Ga and Se was carried out again at the same highest substrate temperature. The film thickness of the CIGS layer was about 2 $\mu$m.

Then, a thin CdS film having a thickness of about 90 nm was deposited as the buffer layer through solution growth, and a ZnO:Al film having a thickness of 0.6 $\mu$m was formed through RF sputtering as the second electrode (translucent electrode) on the buffer layer. Finally, an Al grid electrode was formed through vapor deposition to provide a photoelectric conversion device of the invention. Major production conditions for each Example are shown in Table 1.

The thus obtained photoelectric conversion devices were analyzed using a secondary ion mass spectroscopy (SIMS) apparatus for a concentration distribution of Na in the thickness direction in the photoelectric conversion layer and in areas in the vicinity thereof. The resulting spectra are shown in FIGs. 4-6.

In each of Examples 1-1 to 1-3, the concentration distribution of Na and the concentration distribution of Ga in the photoelectric conversion layer in the thickness direction had a valley-shaped distribution where the concentration gradually decreased from the second electrode (translucent electrode) side, and then gradually increased toward the substrate side.

Table 1 shows values of the concentration $A_N$ of the alkaline (-earth) metal at the valley position, the highest concentration $B_N$ of the alkaline (-earth) metal at a position nearer to the substrate from the valley position, the concentration $A_G$ of Ga at the valley position, the highest concentration $B_G$ of Ga at a position nearer to the substrate from the valley position, $C_N$ (=$B_N/A_N$) $C_G$ (=$B_G/A_G$), and $C_N/C_G$.

In all the Examples, $1.0\times10^{-6} \leq A_N$ [mol/cc] $\leq 2.0\times10^{-5}$ (1) and $1.0 \leq C_N/C_G$ (2) were satisfied.

The photoelectric conversion efficiency of each Example was evaluated using light from a solar simulator (Air Mass (AM) = 1.5, 100 mW/cm$^2$), and found to be 13 to 15%. The results of the evaluation are shown in Table 1.

(Comparative Example 1-1)

A photoelectric conversion device was produced in the same process as in Examples 1-1 to 1-3, except that the highest substrate temperature during the formation of the photoelectric conversion layer was 340 °C, and was evaluated in the same manner.

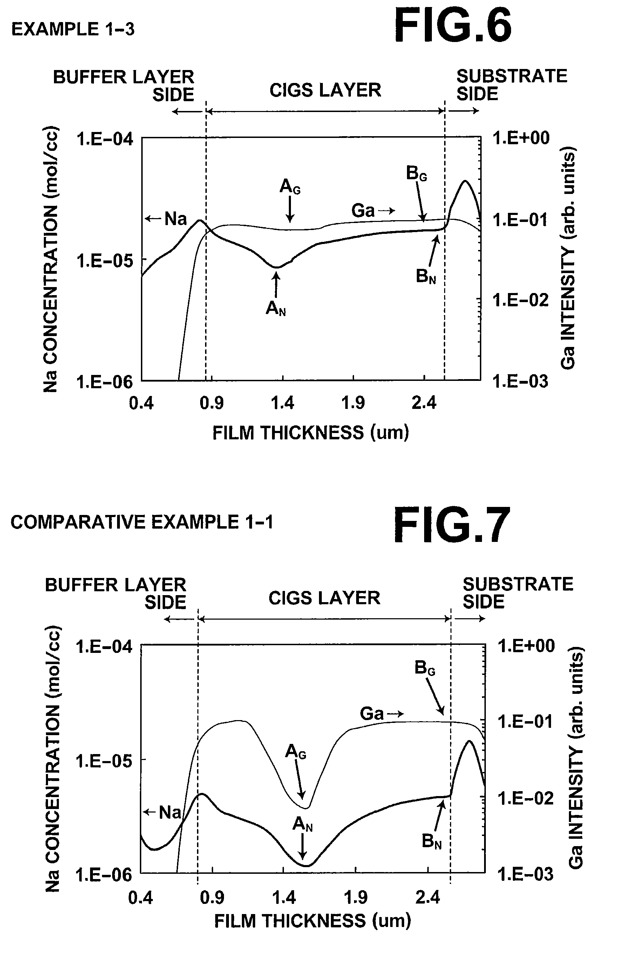

FIG. 7 shows the SIMS spectrum. The major production conditions and the results of the evaluation are shown in Table 1.

In this Comparative Example, although the concentration $A_N$ of the alkaline (-earth) metal at the valley position satisfied the Expression (1), $C_N/C_G$ was too small and did not satisfy the Expression (2). The photoelectric conversion efficiency was 8%.

(Example 2-1)

A white float glass substrate, which contains only an impurity-level of Na, was prepared as the substrate, and a Mo electrode having a size of 3 cm $\times$ 3 cm was formed through RF sputtering on the substrate. The Mo sputtering pressure was 0.3 Pa, and the film thickness of Mo was 0.8 $\mu$m. Subsequently, a 30 nm-thick sodium polymolybdate layer was formed as the alkali metal supplying layer. Specifically, a solution of MoO$_3$ dissolved in an aqueous hydroxide sodium solution was applied on the Mo electrode through spin coating, slowly dried on a hot plate at a temperature of 70 °C, and subjected to a heat treatment at a temperature of 200 °C for one hour to form a Na$_6$Mo$_7$O$_{24}$ layer. Then, a photoelectric conversion device was produced in the same process as in Example 1-2, and was evaluated in the same manner.

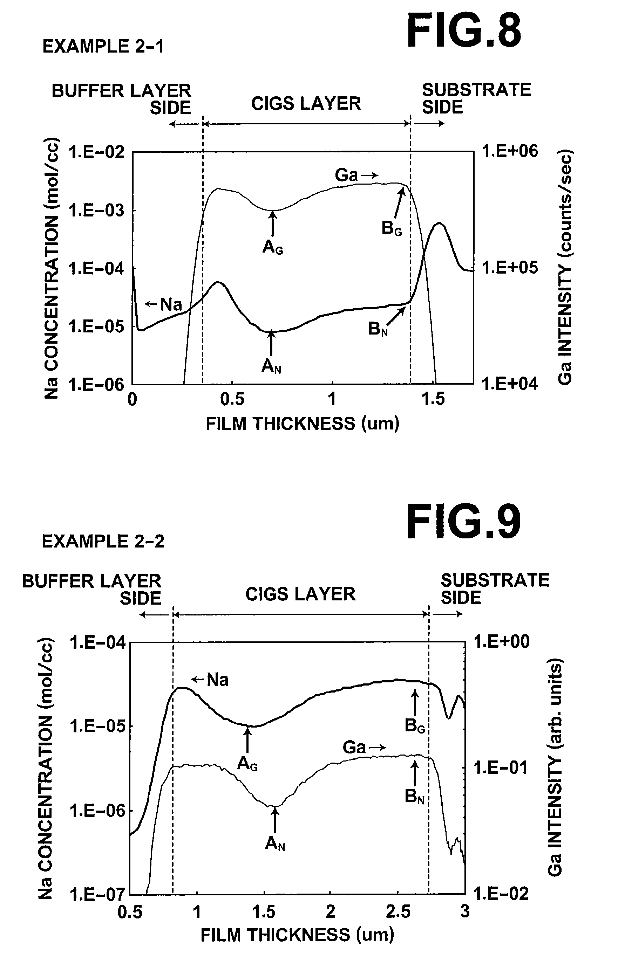

FIG. 8 shows the SIMS spectrum. The major production conditions and the results of the evaluation are shown in Table 1.

Similarly to Examples 1-1 to 1-3, the concentration distribution of Na and the concentration distribution of Ga in the photoelectric conversion layer in the thickness direction were a valley-shaped distribution, where the concentration gradually decreased from the second electrode (translucent electrode) side, and then, gradually increased toward the substrate side, and $A_N$ and $C_N/C_G$ satisfied Expressions (1) and (2). The photoelectric conversion efficiency was 15%.

(Example 2-2)

A white float glass substrate, which contains only an impurity-level of Na, was prepared as the substrate, and a 200 nm-thick sodium silicate layer was formed as the alkali metal supplying layer on the substrate according to S. Ishizuka et al., "Alkali incorporation control in Cu(In,Ga)Se2 thin films using silicate thin layers and applications in enhancing flexible solar cell efficiency", Applied Physics Letters, Vol. 93, 124105, pp. 124105-1 - 124105-3, 2008. Then, a Mo electrode having a size of 3 cm $\times$ 3 cm was formed through RF sputtering on the alkali metal supplying layer. The Mo sputtering pressure was 0.3 Pa, and the film thickness of Mo was 0.8 $\mu$m. Then, a photoelectric conversion device was produced in the same process as in Example 1-2, and was evaluated in the same manner.

FIG. 9 shows the SIMS spectrum. The major production conditions and the results of the evaluation are shown in Table 1.

Similarly to Examples 1-1 to 1-3, the concentration distribution of Na and the concentration distribution of Ga in the photoelectric conversion layer in the thickness direction were a valley-shaped distribution, where the concentration gradually decreased from the second electrode (translucent electrode) side, and then, gradually increased toward the substrate side, and $A_N$ and $C_N/C_G$ satisfied Expressions (1) and (2). The photoelectric conversion efficiency was 15%.

(Comparative Example 2-1)

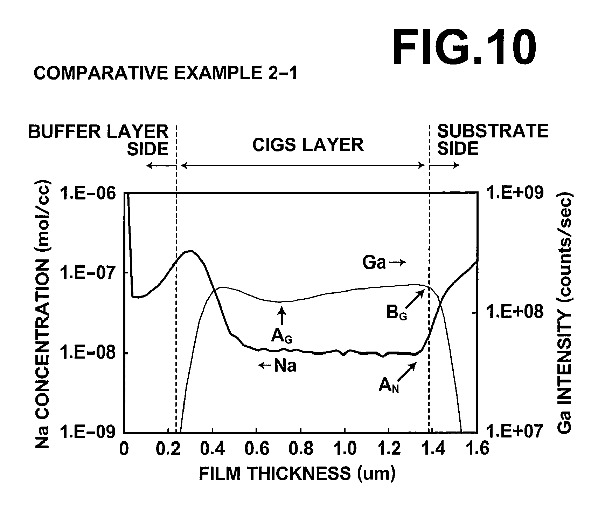

A photoelectric conversion device was produced in the same process as in Example 1-3, except that a white float glass substrate, which contains only an impurity-level of Na, was prepared as the substrate, and was evaluated in the same manner. FIG. 10 shows the SIMS spectrum. The major production conditions and the results of the evaluation are shown in Table 1.

In this Comparative Example, the Na supply to the photoelectric conversion layer from the substrate side was too small, and the concentration distribution of Na in the photoelectric conversion layer in the thickness direction was such that the surface on the substrate side had the lowest concentration. In this Comparative Example, the concentration $A_N$ of the alkaline(-earth) metal at the valley position was too small and did not satisfy Expression (1). In this Comparative Example, there was no area nearer to the substrate from the valley position with a concentration of Na higher than the concentration at the valley position, and there was no highest concentration $B_N$ [mol/cc] of the alkaline(-earth) metal at a position nearer to the substrate from the valley position. $A_G = 1.2 \times 10^8$, $B_G = 1.7 \times 10^8$, and $C_G = 1.4$. The photoelectric conversion efficiency of this device was 10%.

Table 1

| | Substrate | Na Supplying Layer | CIGS Substrate Temperature (°C) | $A_N$ [mol/cc] | $B_N$ [mol/cc] | $C_N$ | $A_G$ [arb. units] | $B_G$ [arb. units] | $C_G$ | $C_N/C_G$ | Conversion Efficiency (%) |
|---|---|---|---|---|---|---|---|---|---|---|---|
| Example 1-1 | SLG | - | 450 | $20\times10^{-6}$ | $7.6\times10^{-6}$ | 3.8 | $3.5\times10^{-2}$ | $9.0\times10^{-2}$ | 26 | 1.5 | 13 |
| Example 1-2 | SLG | - | 500 | $7.0\times10^{-6}$ | $1.6\times10^{-5}$ | 23 | $7.0\times10^{-2}$ | $1.1\times10^{-1}$ | 1.6 | 1.4 | 14 |
| Example 1-3 | SLG | - | 530 | $8.0\times10^{-5}$ | $20\times10^{-5}$ | 2.5 | $7.0\times10^{-2}$ | $1.0\times10^{-1}$ | 1.4 | 1.8 | 15 |
| Comparative Example 1-1 | SLG | - | 340 | $1.2\times10^{-6}$ | $4.4\times10^{-6}$ | 3.7 | $7.0\times10^{-3}$ | $1.0\times10^{-1}$ | 14 | 0.3 | 8 |
| Example 2-1 | White float Glass | Provided | 500 | $8.0\times10^{-6}$ | $25\times10^{5}$ | 3.1 | $3.2\times10^{-5}$ | $4.8\times10^{-5}$ | 1.5 | 2.1 | 15 |
| Example 2-2 | White float Glass | Provided | 500 | $1.1\times10^{-6}$ | $3.5\times10^{-6}$ | 3.2 | $2.0\times10^{-1}$ | $5.0\times10^{-1}$ | 25 | 1.3 | 15 |
| Comparative Example 2-1 | White float Glass | - | 530 | $1.0\times10^{-8}$ | No Value | No Value | $1.2\times10^{8}$ | $1.7\times10^{8}$ | 1.4 | No Value | 10 |

Industrial Applicability

The photoelectric conversion device and the method for producing the photoelectric conversion device of the invention are preferably applicable to applications, such as solar batteries and infrared sensors.

**Claims**

1.  A photoelectric conversion device (1) comprising:

    a layered structure formed on a substrate (10, 11), the layered structure comprising a first electrode (20), a photoelectric conversion semiconductor layer (30) for generating an electric current when it absorbs light, and a second electrode (50), wherein the photoelectric conversion semiconductor layer (30) comprises, as a main component, at least one compound semiconductor comprising a group Ib element, at least two group IIIb elements including Ga, and a group VIb element, and comprises one or two or more alkaline(-earth) metals, **characterized in that**
    a concentration distribution of the alkaline(-earth) metal in the photoelectric conversion semiconductor layer (30) in a thickness direction comprises a valley position with a lowest concentration of the alkaline (-earth) metal and an area with a concentration of the alkaline(-earth) metal higher than the concentration at the valley position, the area being nearer to the substrate from the valley position,
    a concentration distribution of Ga in the photoelectric conversion semiconductor layer (30) in the thickness direction comprises a valley position with a lowest concentration of Ga and an area with a concentration of Ga higher than the concentration at the valley position, the area being nearer to the substrate from the valley position, and
    Expressions (1) and (2) below are satisfied:

    $$1.0 \times 10^{-6} \leq A_N \ [\text{mol/cc}] \leq 2.0 \times 10^{-5} \qquad (1)$$

    and

    $$1.0 \leq C_N/C_G \qquad (2),$$

    where, with respect to the concentration distribution of the alkaline(-earth) metal in the thickness direction in the photoelectric conversion semiconductor layer, $A_N$ [mol/cc] represents the concentration of the alkaline(-earth) metal at the valley position and $B_N$ [mol/cc] represents a highest concentration of the alkaline (-earth) metal at a position nearer to the substrate from the valley position; with respect to the concentration distribution of Ga in the thickness direction in the photoelectric conversion semiconductor layer, $A_G$ [mol/cc] represents the concentration of Ga at the valley position and $B_G$ [mol/cc] represents a highest concentration of Ga at a position nearer to the substrate from the valley position; $C_N$ represents a ratio ($B_N/A_N$) between $A_N$ and $B_N$, and $C_G$ represents a ratio ($B_G/A_G$) between $A_G$ and $B_G$.

2.  The photoelectric conversion device as claimed in claim 1, wherein the main component of the photoelectric conversion semiconductor layer (30) comprises at least one compound semiconductor comprising
    at least one group Ib element selected from the group consisting of Cu and Ag,
    at least two group IIIb elements including Ga selected from the group consisting of Al, Ga and In, and
    at least one group VIb element selected from the group consisting of S, Se and Te.

3.  The photoelectric conversion device as claimed in claim 1 or 2, wherein the photoelectric conversion semiconductor layer (30) comprises Na as the alkaline(-earth) metal.

4.  The photoelectric conversion device as claimed in claim 1, wherein the substrate (10) comprises the alkaline (-earth) metal.

5.  The photoelectric conversion device as claimed in any one of claims 1 to 3, further comprising at least one alkaline (-earth) metal supplying layer (70) provided between the substrate (10, 11) and the photoelectric conversion semiconductor layer (30), the at least one alkaline (-earth) metal supplying layer (70) supplying the alkaline(-earth) metal to the photoelectric conversion semiconductor layer (30) during formation of the photoelectric conversion semiconductor layer (30).

6. The photoelectric conversion device as claimed in any one of claims 1 to 5, wherein the first electrode (20) comprises Mo as a main component.

7. The photoelectric conversion device as claimed in any one of claims 1 to 6, wherein the photoelectric conversion semiconductor layer (30) is formed through vapor deposition by depositing a plurality of metal elements in a plurality of steps at a substrate temperature in the range from 350 to 550 °C.

8. A method for producing the photoelectric conversion device as claimed in any one of claims 1 to 6, the method comprising:

   forming the photoelectric conversion semiconductor layer (30) through vapor deposition by depositing a plurality of metal elements in a plurality of steps at a substrate temperature in the range from 350 to 550 °C.

9. A solar battery comprising the photoelectric conversion device as claimed in any one of claims 1 to 7.

# FIG.1

# FIG.2A

# FIG.2B

FIG.3

# FIG.4

EXAMPLES 1-1

# FIG.5

EXAMPLE 1-2

EXAMPLE 1-3 **FIG.6**

COMPARATIVE EXAMPLE 1-1 **FIG.7**

# FIG.8

EXAMPLE 2-1

# FIG.9

EXAMPLE 2-2

# FIG.10

**COMPARATIVE EXAMPLE 2-1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004158556 A
- JP 9074065 A
- JP 9074213 A
- US 5626688 A

### Non-patent literature cited in the description

- **D. Rudmann et al.** Na incorporation into Cu(In,Ga)Se2 for high-efficiency flexible solar cells on polymer foils. *Journal of Applied Physics,* 2005, vol. 97 (084903), 084903-1084903-5
- **J. R. Tuttle et al.** The Performance of Cu(In,Ga)Se2-Based Solar Cells in Conventional and Concentrator Applications. *Mat. Res. Soc. Symp. Proc.,* 1996, vol. 426, 143-151
- **L. Stolt et al.** THIN FILM SOLAR CELL MODULES BASED ON CU(IN,GA)SE2 PREPARED BY THE COEVAPORATION METHOD. *Proc. 13th EUPVSEC,* 1995, 1451-1455
- **H. Miyazaki et al.** Growth of high-quality CuGaSe2 thin films using ionized Ga precursor. *phys. stat. sol. (a,* 2006, vol. 203, 2603-2608
- *Proceedings of the 68th lecture meeting of The Japan Society of Applied Physics,* 2007
- *Proceedings of the 54th lecture meeting of The Japan Society of Applied Physics,* 2007
- **T. Nakada et al.** CuInSe2-based solar cells by Se-vapor selenization from Se-containing precursors. *Solar Energy Materials and Solar Cells,* 1994, vol. 35, 209-214
- **Nakada et al.** THIN FILMS OF CuInSe2 PRODUCED BY THERMAL ANNEALING OF MULTILAYERS WITH ULTRA-THIN STACKED ELEMENTAL LAYERS. *Proceedings of the 10th European Photovoltaic Solar Energy Conference (EU PVSEC),* 1991, 887-890
- **K. Kushiya.** Tech. Digest 9th Photovoltaic Science and Engineering Conf. Miyazaki. *Intn. PVSEC-9,* 149
- **J.H. Ermer et al.** CdS/CuInSe2 JUNCTIONS FABRICATED BY DC MAGNETRON SPUTTERING OF Cu2Se AND In2Se. *Proceedings of the 18th IEEE Photovoltaic Specialists Conference,* 1985, 1655-1658
- **T. Nakada et al.** Polycrystalline CuInSe2 Thin Films for Solar Cells by Three-Source Magnetron Sputtering. *Japanese Journal of Applied Physics,* 1983, vol. 32 (8B), L1169-L1172
- **T. Nakada et al.** Microstructural Characterization for Sputter-Deposited CuInSe2 Films and Photovoltaic Devices. *Japanese Journal of Applied Physics,* 1995, vol. 34 (9A), 4715-4721
- **T. Wada et al.** Fabrication of Cu(In,Ga)Se2 thin films by a combination of mechanochemical and screen-printing/sintering processes. *physica status solidi (a),* 2006, vol. 203 (11), 2593-2597
- **T. Dullweber et al.** A new approach to high-efficiency solar cells by band gap grading in Cu(In,Ga)Se2 chalcopyrite semiconductors. *Solar Energy Materials and Solar Cells,* 2001, vol. 67, 145-150
- **S. Ishizuka et al.** Alkali incorporation control in Cu(In,Ga)Se2 thin films using silicate thin layers and applications in enhancing flexible solar cell efficiency. *Applied Physics Letters,* 2008, vol. 93 (124105), 124105-1124105-3